(19) **Europäisches Patentamt / European Patent Office / Office européen des brevets**

(11) **EP 3 200 574 B1**

(12) # FASCICULE DE BREVET EUROPEEN

(45) Date de publication et mention de la délivrance du brevet:
**26.02.2020 Bulletin 2020/09**

(51) Int Cl.:
*H05K 7/20* (2006.01)     *B01D 46/00* (2006.01)
*B01D 46/44* (2006.01)     *H05K 7/14* (2006.01)

(21) Numéro de dépôt: **16204278.2**

(22) Date de dépôt: **15.12.2016**

(54) **PROCÉDÉ ET SYSTÈME DE DÉTERMINATION DU NIVEAU D'EFFICACITÉ D'UN SYSTÈME DE VENTILATION D'UNE ENVELOPPE ÉLECTRIQUE**

VERFAHREN UND SYSTEM ZUR BESTIMMUNG DES EFFIZIENZNIVEAUS EINES BELÜFTUNGSSYSTEMS EINER ELEKTRISCHEN HÜLLE

METHOD AND SYSTEM FOR DETERMINING THE LEVEL OF EFFICIENCY OF A VENTILATION SYSTEM OF AN ELECTRICAL ENCLOSURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.01.2016 FR 1650704**

(43) Date de publication de la demande:
**02.08.2017 Bulletin 2017/31**

(73) Titulaire: **Schneider Electric Industries SAS**
**92500 Rueil-Malmaison (FR)**

(72) Inventeurs:
• **AGNAOU, Abderrahmane**
**38050 Grenoble Cedex 09 (FR)**
• **LOPEZ, Josep**
**38050 Grenoble Cedex 09 (FR)**
• **PERRIN, Alain**
**38050 Grenoble Cedex 09 (FR)**
• **CASSAN, Philippe**
**38050 Grenoble Cedex 09 (FR)**

(74) Mandataire: **Tripodi, Paul**
**Schneider Electric Industries SAS**
**Service Propriété Industrielle**
**World Trade Center / 38EE1**
**5 Place Robert Schuman**
**38050 Grenoble Cedex 09 (FR)**

(56) Documents cités:
**EP-A1- 2 077 145    US-A1- 2011 295 524**
**US-A1- 2011 316 706    US-B1- 6 319 114**

**Description**

**Domaine technique de l'invention**

La présente invention se rapporte à un procédé de détermination du niveau d'efficacité d'un système de ventilation d'une enveloppe électrique. L'invention se rapporte également à un système de détermination du niveau d'efficacité d'un système de ventilation d'une enveloppe électrique.

**Etat de la technique**

Pour des raisons d'efficacité énergétique, il est aujourd'hui nécessaire de tenir compte de l'énergie électrique consommée pour la dissipation thermique des appareils électriques logés dans une enveloppe électrique, telle que par exemple une armoire électrique. Pour cette dissipation thermique, l'enveloppe électrique comporte un système de ventilation ayant :

- Une entrée d'air par laquelle est injecté de l'air dans l'enveloppe électrique,
- Au moins un ventilateur destiné à favoriser l'injection de l'air dans l'enveloppe pour refroidir les appareils électriques,
- Une sortie d'air pour évacuer l'air chaud en dehors de l'enveloppe,
- Un filtre positionné au niveau de l'entrée d'air de l'enveloppe et employé pour éviter d'amener des poussières ou autres particules polluantes à l'intérieur de l'enveloppe.

Les document EP2077145 et US 2011/316706 montrent des enveloppes comportant une entrée et une sortie d'air, un ventilateur pour refroidir des appareils, et un filtre pour filtrer l'air entrant dans l'enveloppe.

Le filtre est par exemple composé d'un matériau alvéolaire chargé de capter les particules venant de l'extérieur lors de l'injection d'air dans l'enveloppe et ainsi de permettre l'injection d'un air « propre » dans l'enveloppe électrique. Pour assurer un refroidissement efficace des appareils électriques, le débit d'air en entrée doit toujours être suffisant. Or un encrassement du filtre d'entrée d'air, un dysfonctionnement du ventilateur ou une autre raison peut entraîner une dégradation de ce débit d'air et donc une dégradation du niveau d'efficacité du système de ventilation. Par exemple, en cas d'encrassement du filtre, deux situations distinctes peuvent se produire :

- Dans une première situation, le débit d'air devient insuffisant et les appareils électriques auront alors tendance à s'échauffer, pouvant entraîner des dysfonctionnements, leur arrêt ou leur casse en cas de surchauffe.
- Dans une deuxième situation, le débit d'air nécessaire pour refroidir correctement les appareils électriques logés dans l'enveloppe est maintenu mais sollicite de manière accrue le ventilateur, ce qui à terme peut affecter sa durée de vie.

Il est donc nécessaire de tenir compte du niveau d'efficacité du système de ventilation et notamment du niveau d'encrassement du filtre d'entrée d'air, avant que l'une des deux situations décrites ci-dessus se produise. Pour cela, une vérification périodique du niveau d'efficacité du système de ventilation est souhaitable. En ce qui concerne le filtre d'entrée d'air, cette vérification peut être réalisée par un opérateur qui extrait le filtre de son logement et qui vérifie son niveau d'encrassement. Cependant, cette méthode s'avère trop contraignante et difficile à mettre en œuvre dans des installations qui comportent un nombre important d'enveloppes électriques. Il existe donc des solutions électroniques qui permettent de déterminer le niveau d'encrassement du filtre et d'indiquer visuellement ce niveau d'encrassement à l'opérateur. La détermination du niveau d'encrassement doit alors être la plus simple et la plus fiable possible, en employant un minimum de capteurs.

Le but de l'invention est de proposer un procédé de détermination du niveau d'efficacité d'un système de ventilation d'une enveloppe électrique, ce procédé étant simple à mettre en œuvre et employant un minimum de capteurs et des capteurs simples et robustes.

**Exposé de l'invention**

Ce but est atteint par un procédé de détermination du niveau d'efficacité d'un système de ventilation d'une enveloppe électrique destinée à loger un ou plusieurs appareils électriques, ledit système de ventilation comprenant une entrée d'air, au moins un ventilateur pour favoriser une injection d'air à l'intérieur de l'enveloppe en vue de refroidir chaque appareil électrique, un filtre d'entrée d'air agencé pour filtrer l'air injecté à l'intérieur de l'enveloppe et une sortie d'air agencée pour permettre d'évacuer l'air chaud en dehors de l'enveloppe, ledit procédé comportant :

- une phase d'apprentissage comprenant une étape de détermination d'un profil de puissance dissipée par effet joule dans l'enveloppe électrique par chaque appareil électrique, pendant une période d'apprentissage,
- une phase d'évaluation du niveau d'efficacité du système de ventilation, comprenant :

  - une étape de détermination du débit d'air moyen du ventilateur sur une période d'évaluation à partir d'un profil de la température de l'air à l'extérieur de l'enveloppe obtenu sur ladite période d'évaluation, d'un profil de la température de l'air à la sortie de l'enveloppe et dudit profil de puissance dissipée déterminé lors de la phase d'apprentissage,
  - une étape de comparaison du débit d'air moyen déterminé sur ladite période d'évaluation avec une ou plusieurs valeurs seuils en vue de déterminer le niveau d'efficacité du système de ventilation.

Selon une particularité, le procédé comporte une étape de collecte de données de températures de l'air à l'extérieur de l'enveloppe pendant la période d'apprentissage à des instants de collecte déterminés, séparés d'un pas de temps régulier.

Selon une autre particularité, le procédé comporte une étape de collecte de données de températures de l'air à la sortie de l'enveloppe pendant la période d'apprentissage à des instants de collecte déterminés, séparés dudit pas de temps régulier.

Selon une autre particularité, le profil de la puissance dissipée par effet joule par les appareils électriques est réalisé à partir des puissances instantanées déterminées pour chaque instant de collecte de la période d'apprentissage, chaque puissance instantanée étant déterminée à partir de la température de l'air à la sortie de l'enveloppe à un instant de collecte de la période d'apprentissage, de la température de l'air à l'extérieur de l'enveloppe audit instant de collecte de la période d'apprentissage et d'un débit d'air initial du ventilateur.

Selon une autre particularité, le procédé comporte une étape de collecte de données de températures de l'air à l'extérieur de l'enveloppe pendant la période d'évaluation à des instants de collecte déterminés, séparés d'un pas de temps régulier.

Selon une autre particularité, le procédé comporte une étape de collecte de données de températures de l'air à la sortie de l'enveloppe pendant la période d'évaluation à des instants de collecte déterminés, séparés dudit pas de temps régulier.

Selon une autre particularité, lors de la phase d'évaluation, il comporte une étape de détermination du débit d'air instantané du ventilateur à chacun des instants de collecte de la période d'évaluation, à partir de la puissance dissipée par effet joule par les appareils électriques logés dans l'enveloppe et déterminée lors de la phase d'apprentissage à un instant correspondant de la période d'apprentissage, de la température de l'air à l'extérieur de l'enveloppe mesurée audit instant et de la température de l'air à la sortie de l'enveloppe mesurée audit instant.

Selon une autre particularité, le débit moyen correspond à la moyenne des débits instantanés déterminés à chaque instant lorsque le ventilateur est en fonctionnement.

Selon une autre particularité, les valeurs seuils sont fixés à partir d'un débit d'air initial du ventilateur.

L'invention concerne également un système de détermination du niveau d'efficacité d'un système de ventilation d'une enveloppe électrique destinée à loger un ou plusieurs appareils électriques, ledit système de ventilation comprenant une entrée d'air, au moins un ventilateur pour favoriser une injection d'air à l'intérieur de l'enveloppe en vue de refroidir chaque appareil électrique, un filtre d'entrée d'air agencé pour filtrer l'air injecté à l'intérieur de l'enveloppe et une sortie d'air agencée pour permettre d'évacuer l'air chaud en dehors de l'enveloppe, ledit système de détermination comportant une unité de traitement qui comprend :

- Un module d'apprentissage comprenant un module de détermination d'un profil de puissance dissipée par effet joule dans l'enveloppe électrique par chaque appareil électrique, pendant une période d'apprentissage,
- Un module d'évaluation du niveau d'efficacité du système de ventilation, comprenant :

  - Un module de détermination du débit d'air moyen du ventilateur sur une période d'évaluation à partir d'un profil de la température de l'air à l'extérieur de l'enveloppe obtenu sur ladite période d'évaluation, d'un profil de la température de l'air à la sortie de l'enveloppe et dudit profil de puissance dissipée déterminé lors de la phase d'apprentissage,
  - Un module de comparaison du débit d'air moyen déterminé sur ladite période d'évaluation avec une ou plusieurs valeurs seuils en vue de déterminer le niveau d'efficacité du système de ventilation.

Selon une particularité, l'unité de traitement est agencée pour collecter des données de températures de l'air à l'extérieur de l'enveloppe pendant la période d'apprentissage à des instants de collecte déterminés, séparés d'un pas de temps régulier.

Selon une autre particularité, l'unité de traitement est agencée pour collecter des données de températures de l'air à la sortie de l'enveloppe pendant la période d'apprentissage à des instants de collecte déterminés, séparés dudit pas de temps régulier.

Selon une autre particularité, le profil de la puissance dissipée par effet joule par les appareils électriques est réalisé à partir des puissances instantanées déterminées pour chaque instant de collecte de la période d'apprentissage, chaque puissance instantanée étant déterminée par un module à partir de la température de l'air à la sortie de l'enveloppe à un instant de collecte de la période d'apprentissage, de la température de l'air à l'extérieur de l'enveloppe audit instant de collecte de la période d'apprentissage et d'un débit d'air initial du ventilateur.

Selon une autre particularité, l'unité de traitement est agencée pour collecter des données de températures de l'air à l'extérieur de l'enveloppe (1) pendant la période d'évaluation à des instants de collecte déterminés, séparés d'un pas de temps régulier.

Selon une autre particularité, l'unité de traitement est agencée pour collecter des données de températures de l'air à la sortie de l'enveloppe pendant la période d'évaluation à des instants de collecte déterminés, séparés dudit pas de temps régulier. Selon une autre particularité, le module d'évaluation comporte un module de détermination du débit d'air instantané du ventilateur à chacun des instants de collecte de la période d'évaluation, à partir de la puissance dissipée par effet joule par les appareils électriques logés dans l'enveloppe et déterminée lors de la phase d'apprentissage à un instant correspondant de la période d'apprentissage, de la température de l'air à l'extérieur de l'enveloppe mesurée audit instant et de la température de l'air à la sortie de l'enveloppe mesurée audit instant.

Selon une autre particularité, le débit moyen correspond à la moyenne des débits instantanés déterminés à chaque instant lorsque le ventilateur est en fonctionnement.

Selon une autre particularité, les valeurs seuils sont fixés à partir d'un débit d'air initial du ventilateur.

## Brève description des figures

D'autres caractéristiques et avantages vont apparaître dans la description détaillée qui suit faite en regard des dessins annexés dans lesquels :

- La figure 1 représente de manière schématique l'architecture d'une enveloppe électrique et le système de détermination du niveau d'efficacité du système de ventilation employé sur l'enveloppe, l'enveloppe étant vue de face,
- La figure 2 représente un diagramme illustrant les différentes étapes du procédé de détermination du niveau d'efficacité du système de ventilation.

## Description détaillée d'au moins un mode de réalisation

L'invention concerne un procédé et un système de détermination du niveau d'efficacité du système de ventilation d'une enveloppe électrique.

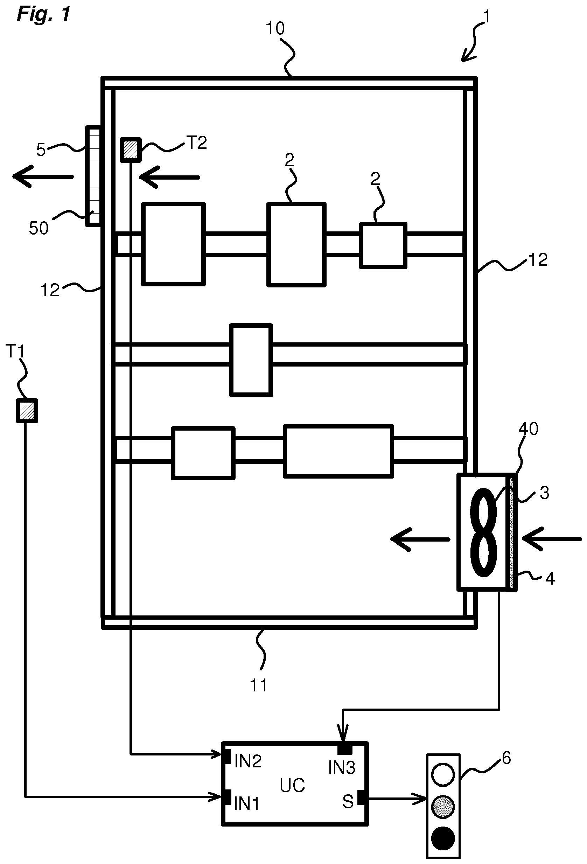

En référence à la figure 1, nous prenons comme exemple une enveloppe électrique 1 qui présente une forme parallélépipédique comprenant une paroi supérieure 10, une paroi inférieure 11 et quatre parois latérales 12 opposées deux à deux. Bien entendu, le procédé et le système de l'invention pourront s'adapter à tous types, toutes formes et tailles d'enveloppes électriques.

L'enveloppe électrique 1 est destinée à loger des appareils électriques 2 et comporte un système de ventilation qui présente :

- Une entrée d'air 4 par laquelle est injecté de l'air à l'intérieur de l'enveloppe électrique 1,

- Une sortie d'air 5 pour évacuer l'air chaud vers l'extérieur de l'enveloppe électrique.

- Au moins un ventilateur 3 positionné au niveau de l'entrée d'air ou de la sortie d'air. Lorsqu'il est activé, il favorise l'injection d'air à l'intérieur de l'enveloppe 1 par refoulement lorsqu'il est situé au niveau de l'entrée d'air ou par aspiration lorsqu'il est situé au niveau de la sortie d'air.

- Un filtre d'entrée d'air 40 positionné au niveau de l'entrée d'air, en amont du ventilateur 3 par rapport au sens d'injection d'air lorsque le ventilateur est à l'entrée, pour filtrer l'air injecté dans l'enveloppe électrique 1. Ce filtre 40 comporte par exemple une structure alvéolaire permettant de capter les impuretés et d'empêcher que celles-ci ne pénètrent dans l'enveloppe.

Sur la figure 1, l'entrée d'air et la sortie d'air sont représentées sur les deux parois latérales opposées de l'enveloppe et transversales par rapport au plan du dessin de l'enveloppe vue de face. Il faut bien entendu comprendre qu'elles pourraient être positionnées sur les deux autres parois latérales opposées situées dans les plans parallèles au plan du dessin de l'enveloppe vue de face. De même, l'entrée d'air ou la sortie d'air pourrait être positionnée sur la paroi supérieure et, respectivement la sortie d'air ou l'entrée d'air positionnée sur une paroi de l'armoire de manière à permettre un écoulement d'air sur tous les appareils électriques logés dans l'enveloppe.

Une première grille (non représentée) associée audit filtre 40 pourra être positionnée sur l'entrée d'air. De même, une deuxième grille 50 pourra être positionnée sur la sortie d'air.

Le système de l'invention qui permet de déterminer le niveau d'efficacité de ce système de ventilation comporte :

- Un premier capteur de température T1 positionné à l'extérieur de l'enveloppe de manière à mesurer la température ambiante de la pièce dans laquelle est située l'enveloppe électrique 1.

- Un deuxième capteur de température T2 positionné à l'intérieur de l'enveloppe 1 de manière à mesurer la température de l'air qui sort vers l'extérieur de l'enveloppe électrique.

- Une unité de traitement UC comprenant notamment un microcontrôleur destiné à déterminer le niveau d'efficacité du système de ventilation et comprenant :

  - Une première entrée IN1 à laquelle est connecté le premier capteur de température T1 en vue de recevoir les données mesurées par ce capteur.

  - Une deuxième entrée IN2 à laquelle est connecté le deuxième capteur de température T2 en vue de recevoir les données mesurées par ce capteur.

  - Une troisième entrée IN3 recevant l'état (0/1) du ventilateur, c'est-à-dire des données représentatives de l'état marche ou de l'état arrêt du ventilateur. Cette troisième entrée IN3 prend la valeur 1 si le ventilateur est à l'état marche ou la valeur 0 si le ventilateur est à l'état arrêt. Cette donnée pourra également déjà à disposition de l'unité de traitement si c'est elle qui est chargée de commander la mise en route du ventilateur 3.

  - Au moins une sortie S sur laquelle peut être envoyé un signal représentatif du niveau d'efficacité du système de ventilation. Une unité de signalisation 6 visuelle, sonore ou autre, sera par exemple connectée sur ladite sortie S en vue d'indiquer le niveau d'efficacité du système de ventilation.

Préférentiellement, comme représenté sur la figure 1, le système de l'invention sera particulièrement efficace avec l'architecture suivante :

- Une entrée d'air 4 positionnée sur la partie inférieure ou supérieure d'une paroi latérale 12 de l'enveloppe,

- Une sortie d'air 5 positionnée, respectivement sur la partie supérieure ou inférieure, d'une paroi latérale 12, à l'opposé de l'entrée d'air 4,

- Le deuxième capteur de température T2 positionné à l'intérieur de l'enveloppe 1 au niveau de la sortie d'air, en amont de la grille de sortie, pour mesurer la température de l'air qui sort de l'enveloppe électrique. Ce capteur T2 pourra être situé à l'intérieur ou à l'extérieur de l'enveloppe.

Bien entendu, d'autres agencements aussi efficaces pourraient être prévus, avec des résultats similaires.

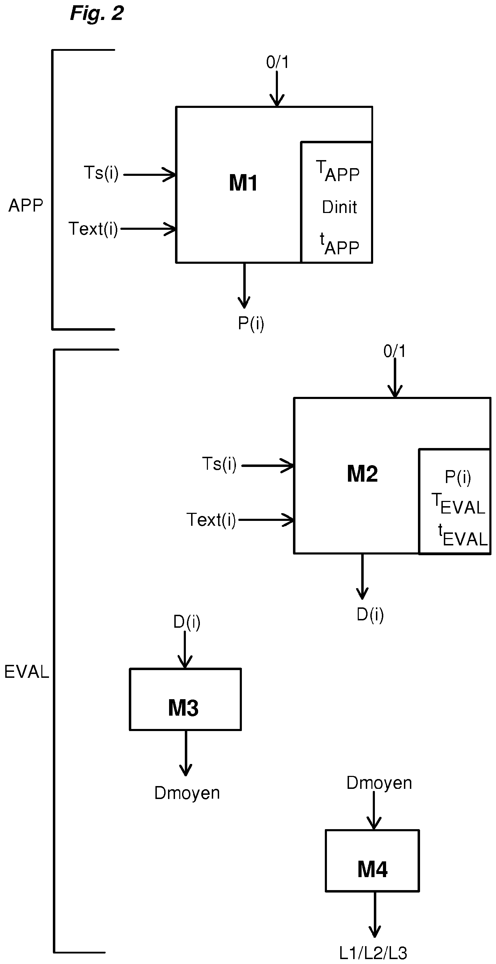

A partir du système tel que décrit ci-dessus, le procédé de l'invention mis en œuvre grâce au système de l'invention, comporte deux phases distinctes, une phase d'apprentissage (APP) et une phase d'évaluation (EVAL) du niveau d'encrassement. La figure 2 illustre les différentes phases de fonctionnement du système de l'invention.

**- Phase d'apprentissage (APP)**

La phase d'apprentissage est mise en œuvre par un module logiciel d'apprentissage de l'unité de traitement UC et est destinée à déterminer un profil de puissance dissipée par effet joule par les appareils électriques 2 présents dans l'enveloppe sur une période d'apprentissage $T_{APP}$ de durée déterminée. Cette période d'apprentissage $T_{APP}$ est par exemple d'une durée de 24 heures afin de pouvoir balayer l'ensemble des cycles de fonctionnement des appareils électriques 2 présents dans l'enveloppe 1.

Au cours de la période d'apprentissage, l'unité de traitement UC récupère sur sa première entrée IN1 et sur sa deuxième entrée IN2 des données de température à plusieurs instants successifs au cours de la période d'apprentissage, respectivement en provenance du premier capteur de température T1 et du deuxième capteur de température T2. Les instants de collecte des données de température sont préférentiellement séparés d'un pas de temps régulier

$t_{APP}$, par exemple fixé à 10 secondes. La collecte des données pourra être commandée par l'unité de traitement UC ou par chaque capteur de température après synchronisation temporelle avec l'unité de traitement UC.

Ainsi, l'unité de traitement UC mémorise les données de température pour chaque instant de collecte i (avec i allant de 1 à n et n valant 8640 avec une période d'apprentissage de 24 heures et un pas de temps de 10 secondes). L'unité de traitement mémorise ainsi :

$$T_{ext}(i) = [T_{ext}(1), T_{ext}(2), T_{ext}(3), T_{ext}(4), \ldots, T_{ext}(n)]$$

$$T_s(i) = [T_s(1), T_s(2), T_s(3), T_s(4), \ldots, T_s(n)]$$

Pour chaque instant, un premier module logiciel M1 du module d'apprentissage détermine la puissance instantanée dissipée par effet joule par les appareils électriques logées dans l'enveloppe. Pour cela, l'unité de traitement procède de la manière suivante :

Pour i=1 à i=n,

Si IN3=1, alors la puissance dissipée vaut :

$$P(i) = D_{init} \times \left[\frac{T_s(i) - T_{ext}(i)}{3}\right]$$

Sinon :

$$P(i) = 0$$

Dans lesquels $D_{init}$ correspond au débit initial du ventilateur 3 en $m^3/s$. Ce débit initial sera par exemple indiqué dans les spécifications du ventilateur 3.

Une fois les puissances dissipées instantanées calculées pour chaque instant i de mesure sur la période d'apprentissage $T_{APP}$, ces données sont mémorisées par l'unité de traitement UC afin d'être employées lors de chaque phase d'évaluation du niveau d'efficacité du système de ventilation de l'enveloppe électrique.

## - Phase d'évaluation (EVAL)

Une phase d'évaluation EVAL est mise en œuvre par un module logiciel d'évaluation de l'unité de traitement UC et consiste à déterminer le niveau d'efficacitié du système de ventilation. Elle est par exemple mise en œuvre sur une période d'évaluation $T_{EVAL}$, préférentiellement de durée identique à la durée d'apprentissage. Elle sera donc par exemple de 24 heures.

Au cours de la période d'évaluation, l'unité de traitement UC récupère sur sa première entrée IN1 et sur sa deuxième entrée IN2 des données de température à plusieurs instants successifs au cours de la période d'apprentissage, respectivement en provenance du premier capteur de température t1 et du deuxième capteur de température T2. Les instants de collecte des données de température sont séparés d'un pas de temps régulier $t_{EVAL}$ identique à celui employé lors de la phase d'apprentissage qui est par exemple fixé à 10 secondes.

Ainsi, l'unité de traitement UC mémorise les données de température pour chaque instant de collecte i (avec i allant de 1 à n et n valant 8640 avec une période d'apprentissage de 24 heures et un pas de temps de 10 secondes). L'unité de traitement mémorise ainsi :

$$T_{ext}(i) = [T_{ext}(1), T_{ext}(2), T_{ext}(3), T_{ext}(4), \ldots, T_{ext}(n)]$$

$$T_s(i) = [T_s(1), T_s(2), T_s(3), T_s(4), \ldots, T_s(n)]$$

Ensuite, un deuxième module logiciel M2 du module d'évaluation détermine le débit d'air instantané du ventilateur 3 pour chaque instant de mesure i de la manière suivante :

Pour i=1 à i=n,

Si IN3=1, alors le débit d'air D(i) vaut :

$$D(i) = 3 \times [P(i)/(T_s(i) - T_{ext}(i))]$$

Sinon :

$$D(i) = 0$$

Avec P(i) qui correspond à la puissance dissipée par effet joule déterminée lors de la phase d'apprentissage pour le même instant i de la période d'apprentissage.

Préférentiellement, l'unité de traitement UC met en œuvre une étape de synchronisation des données du profil de puissance déterminées lors de la phase d'apprentissage avec les valeurs de températures collectées lors de la phase d'évaluation. La synchronisation sera par exemple mise en œuvre en faisant correspondre les valeurs maximales du profil de puissance avec les valeurs maximales de températures mesurées par le deuxième capteur de température.

Pour déterminer le niveau d'efficacité du système de ventilation, un troisième module M3 du module d'évaluation détermine un débit moyen $D_{moyen}$ qui est calculé sur la base des débits instantanés non nuls déterminés à chaque instant i. Pour toutes les valeurs de $D(i) \neq 0$ obtenues lorsque le ventilateur est en fonctionnement, ce débit moyen vaut ainsi :

$$D_{moyen} = \sum_{1}^{n} D(i)/N$$

Avec N qui correspond au nombre de valeurs pour lesquelles le ventilateur est en fonctionnement.

A partir du débit moyen déterminé, un quatrième module logiciel M4 du module d'évaluation détermine le niveau d'efficacité du système de ventilation de l'enveloppe électrique. Pour cela, il met en œuvre une étape de comparaison du débit moyen $D_{moyen}$ obtenu avec une ou plusieurs valeurs seuils. Ces valeurs seuils sont par exemple déterminées sur la base du débit initial $D_{init}$ évoqué ci-dessus. Par exemple, le quatrième module logiciel M4 de l'unité de traitement UC met en œuvre les tests suivants :

- Si $D_{moyen} > D_{init} \times 70\%$ alors la filtration d'air fonctionne correctement, correspondant à un premier niveau L1 d'efficacité du système de ventilation.

- Si $Dinit \times 40\% < D_{moyen} < D_{init} \times 70\%$ alors la filtration d'air présente un fonctionnement moyen, correspondant à un deuxième niveau L2 d'efficacité du système de ventilation et au fait qu'une intervention sera à prévoir prochainement pour déterminer la cause de la relative inefficacité du système.

- Si $D_{moyen} < D_{init} \times 40\%$ alors la filtration d'air ne fonctionne pas correctement, correspondant à un troisième niveau L3 d'efficacité du système de ventilation de l'enveloppe et au fait qu'une intervention est nécessaire pour déterminer la cause de l'inefficacité du système.

Bien entendu, d'autres valeurs seuils pourraient être employées, selon les exigences de l'installation.

Selon le niveau (L1, L2 ou L3) d'efficacité déterminé, l'unité de traitement UC pourra par exemple commander l'allumage d'un indicateur lumineux distinct de l'unité de signalisation 6.

Le procédé et le système de l'invention présente ainsi de nombreux avantages, parmi lesquels :

- Une détection du niveau d'efficacité d'un système de ventilation qui est simple car elle utilise un nombre minimum de capteurs.

- Une détection qui est fiable car les capteurs employés sont des simples capteurs de températures.

- Une solution peu coûteuse car elle utilise un faible nombre de capteurs et une capacité de traitement limitée.

**Revendications**

1. Procédé de détermination du niveau d'efficacité d'un système de ventilation d'une enveloppe électrique (1) destinée à loger un ou plusieurs appareils électriques (2), ledit système de ventilation comprenant une entrée d'air (4), au moins un ventilateur (3) pour favoriser une injection d'air à l'intérieur de l'enveloppe (1) en vue de refroidir chaque appareil électrique (2), un filtre d'entrée d'air (40) agencé pour filtrer l'air injecté à l'intérieur de l'enveloppe (1) et une sortie d'air (5) agencée pour permettre d'évacuer l'air chaud en dehors de l'enveloppe (1), **caractérisé en ce qu'**il comporte :

   - une phase d'apprentissage (APP) comprenant une étape de détermination d'un profil de puissance dissipée par effet joule dans l'enveloppe électrique (1) par chaque appareil électrique, pendant une période d'apprentissage ($T_{APP}$),
   - une phase d'évaluation (EVAL) du niveau d'efficacité du système de ventilation, comprenant :

      - une étape de détermination du débit d'air moyen du ventilateur sur une période d'évaluation ($T_{EVAL}$) à partir d'un profil de la température de l'air à l'extérieur de l'enveloppe obtenu sur ladite période d'évaluation, d'un profil de la température de l'air à la sortie de l'enveloppe et dudit profil de puissance dissipée déterminé lors de la phase d'apprentissage,
      - une étape de comparaison du débit d'air moyen ($D_{moyen}$) déterminé sur ladite période d'évaluation avec une ou plusieurs valeurs seuils en vue de déterminer le niveau d'efficacité du système de ventilation.

2. Procédé de détermination selon la revendication 1, **caractérisé en ce qu'**il comporte une étape de collecte de données de températures de l'air à l'extérieur de l'enveloppe pendant la période d'apprentissage à des instants (i) de collecte déterminés, séparés d'un pas de temps régulier ($t_{APP}$).

3. Procédé de détermination selon la revendication 2, **caractérisé en ce qu'**il comporte une étape de collecte de données de températures de l'air à la sortie de l'enveloppe pendant la période d'apprentissage à des instants de collecte déterminés, séparés dudit pas de temps régulier ($t_{APP}$).

4. Procédé de détermination selon la revendication 3, **caractérisé en ce que** le profil de la puissance dissipée par effet joule par les appareils électriques est réalisé à partir des puissances instantanées (P(i)) déterminées pour chaque instant de collecte de la période d'apprentissage, chaque puissance instantanée étant déterminée à partir de la température de l'air à la sortie de l'enveloppe à un instant de collecte de la période d'apprentissage, de la température de l'air à l'extérieur de l'enveloppe audit instant de collecte de la période d'apprentissage et d'un débit d'air initial du ventilateur (3).

5. Procédé de détermination selon la revendication 1, **caractérisé en ce qu'**il comporte une étape de collecte de données de températures de l'air à l'extérieur de l'enveloppe (1) pendant la période d'évaluation ($T_{EVAL}$) à des instants de collecte déterminés, séparés d'un pas de temps régulier ($t_{EVAL}$).

6. Procédé de détermination selon la revendication 5, **caractérisé en ce qu'**il comporte une étape de collecte de données de températures de l'air à la sortie de l'enveloppe (1) pendant la période d'évaluation à des instants de collecte déterminés, séparés dudit pas de temps régulier ($t_{EVAL}$).

7. Procédé de détermination selon la revendication 6, **caractérisé en ce que**, lors de la phase d'évaluation, il comporte une étape de détermination du débit d'air (D(i)) instantané du ventilateur (3) à chacun des instants de collecte de la période d'évaluation, à partir de la puissance dissipée par effet joule par les appareils électriques (2) logés dans l'enveloppe et déterminée lors de la phase d'apprentissage (APP) à un instant correspondant de la période d'apprentissage ($T_{APP}$), de la température de l'air à l'extérieur de l'enveloppe mesurée audit instant et de la température de l'air à la sortie de l'enveloppe mesurée audit instant.

8. Procédé de détermination selon la revendication 7, **caractérisé en ce que** le débit moyen ($D_{moyen}$) correspond à la moyenne des débits instantanés déterminés à chaque instant lorsque le ventilateur est en fonctionnement.

9. Procédé de détermination selon l'une des revendications 1 à 8, **caractérisé en ce que** les valeurs seuils sont fixés à partir d'un débit d'air initial du ventilateur (3).

10. Système de détermination du niveau d'efficacité d'un système de ventilation d'une enveloppe électrique (1) destinée à loger un ou plusieurs appareils électriques (2), ledit système de ventilation comprenant une entrée d'air (4), au moins un ventilateur (3) pour favoriser une injection d'air à l'intérieur de l'enveloppe (1) en vue de refroidir chaque appareil électrique (2), un filtre d'entrée d'air (40) agencé pour filtrer l'air injecté à l'intérieur de l'enveloppe (1) et une sortie d'air (5) agencée pour permettre d'évacuer l'air chaud en dehors de l'enveloppe (1), **caractérisé en ce qu'**il comporte une unité de traitement comprenant :

    - Un module d'apprentissage comprenant un module (M1) de détermination d'un profil de puissance dissipée par effet joule dans l'enveloppe électrique (1) par chaque appareil électrique, pendant une période d'apprentissage ($T_{APP}$),
    - Un module d'évaluation (EVAL) du niveau d'efficacité du système de ventilation, comprenant :

        - Un module (M3) de détermination du débit d'air moyen du ventilateur (3) sur une période d'évaluation ($T_{EVAL}$) à partir d'un profil de la température de l'air à l'extérieur de l'enveloppe obtenu sur ladite période d'évaluation, d'un profil de la température de l'air à la sortie de l'enveloppe et dudit profil de puissance dissipée déterminé lors de la phase d'apprentissage,
        - Un module (M4) de comparaison du débit d'air moyen ($D_{moyen}$) déterminé sur ladite période d'évaluation avec une ou plusieurs valeurs seuils en vue de déterminer le niveau d'efficacité du système de ventilation.

11. Système de détermination selon la revendication 10, **caractérisé en ce que** l'unité de traitement (UC) est agencée pour collecter des données de températures de l'air à l'extérieur de l'enveloppe pendant la période d'apprentissage à des instants (i) de collecte déterminés, séparés d'un pas de temps régulier ($t_{APP}$).

12. Système de détermination selon la revendication 11, **caractérisé en ce que** l'unité de traitement est agencée pour collecter des données de températures de l'air à la sortie de l'enveloppe pendant la période d'apprentissage à des instants de collecte déterminés, séparés dudit pas de temps régulier ($t_{APP}$).

13. Système de détermination selon la revendication 12, **caractérisé en ce que** le profil de la puissance dissipée par effet joule par les appareils électriques est réalisé à partir des puissances instantanées ($P(i)$) déterminées pour chaque instant de collecte de la période d'apprentissage, chaque puissance instantanée étant déterminée par un module (M1) à partir de la température de l'air à la sortie de l'enveloppe à un instant de collecte de la période d'apprentissage, de la température de l'air à l'extérieur de l'enveloppe audit instant de collecte de la période d'apprentissage et d'un débit d'air initial du ventilateur (3).

14. Système de détermination selon la revendication 10, **caractérisé en ce que** l'unité de traitement (UC) est agencée pour collecter des données de températures de l'air à l'extérieur de l'enveloppe (1) pendant la période d'évaluation ($T_{EVAL}$) à des instants de collecte déterminés, séparés d'un pas de temps régulier ($t_{EVAL}$).

15. Système de détermination selon la revendication 14, **caractérisé en ce que** l'unité de traitement (UC) est agencée pour collecter des données de températures de l'air à la sortie de l'enveloppe (1) pendant la période d'évaluation à des instants de collecte déterminés, séparés dudit pas de temps régulier ($t_{EVAL}$).

16. Système de détermination selon la revendication 15, **caractérisé en ce que** le module d'évaluation comporte un module (M2) de détermination du débit d'air ($D(i)$) instantané du ventilateur (3) à chacun des instants de collecte de la période d'évaluation, à partir de la puissance dissipée par effet joule par les appareils électriques (2) logés dans l'enveloppe et déterminée lors de la phase d'apprentissage (APP) à un instant correspondant de la période d'apprentissage ($T_{APP}$), de la température de l'air à l'extérieur de l'enveloppe mesurée audit instant et de la température de l'air à la sortie de l'enveloppe mesurée audit instant.

17. Système de détermination selon la revendication 16, **caractérisé en ce que** le débit moyen ($D_{moyen}$) correspond à la moyenne des débits instantanés déterminés à chaque instant lorsque le ventilateur est en fonctionnement.

18. Système de détermination selon l'une des revendications 10 à 17, **caractérisé en ce que** les valeurs seuils sont fixés à partir d'un débit d'air initial du ventilateur (3).

**Patentansprüche**

1. Verfahren zum Bestimmen des Effizienzniveaus eines Belüftungssystems eines elektrischen Gehäuses (1), das dazu bestimmt ist, ein oder mehrere elektrische Geräte (2) aufzunehmen, wobei das Belüftungssystem einen Lufteinlass (4), mindestens einen Lüfter (3), um das Einblasen von Luft in den Innenraum des Gehäuses (1) im Hinblick auf das Kühlen jedes elektrischen Geräts (2) zu begünstigen, einen Lufteinlassfilter (40), der dazu eingerichtet ist, die in den Innenraum des Gehäuses (1) eingeblasene Luft zu filtern, und einen Luftauslass (5), der dazu eingerichtet ist, das Abführen der warmen Luft aus dem Gehäuse (1) heraus zu ermöglichen, umfasst, **dadurch gekennzeichnet, dass** es beinhaltet:

   - eine Lernphase (APP), die einen Schritt des Bestimmens eines Profils der Leistung umfasst, die durch Joule-Effekt in dem elektrischen Gehäuse (1) von jedem elektrischen Gerät während eines Lernzeitraums ($T_{APP}$) abgegeben wird,
   - eine Phase des Bewertens (EVAL) des Effizienzniveaus des Belüftungssystems, die umfasst:

     - einen Schritt des Bestimmens des mittleren Luftvolumenstroms des Lüfters über einen Bewertungszeitraum ($T_{EVAL}$) anhand eines über den Bewertungszeitraum erhaltenen Profils der Temperatur der Luft außerhalb des Gehäuses, eines Profils der Temperatur der Luft am Auslass des Gehäuses und des während der Lernphase bestimmten Profils der abgegebenen Leistung,
     - einen Schritt des Vergleichens des über den Bewertungszeitraum bestimmten mittleren Luftvolumenstroms ($D_{moyen}$) mit einem oder mehreren Schwellenwerten im Hinblick auf das Bestimmen des Effizienzniveaus des Belüftungssystems.

2. Bestimmungsverfahren nach Anspruch 1, **dadurch gekennzeichnet, dass** es einen Schritt des Erfassens von Temperaturdaten der Luft außerhalb des Gehäuses während des Lernzeitraums zu bestimmten Erfassungszeitpunkten (i) beinhaltet, die durch ein regelmäßiges Zeitintervall ($t_{APP}$) getrennt sind.

3. Bestimmungsverfahren nach Anspruch 2, **dadurch gekennzeichnet, dass** es einen Schritt des Erfassens von Temperaturdaten der Luft am Auslass des Gehäuses während des Lernzeitraums zu bestimmten Erfassungszeitpunkten beinhaltet, die durch das regelmäßige Zeitintervall ($t_{APP}$) getrennt sind.

4. Bestimmungsverfahren nach Anspruch 3, **dadurch gekennzeichnet, dass** das Profil der durch Joule-Effekt von den elektrischen Geräten abgegebenen Leistung anhand der momentanen Leistungen (P(i)) erstellt wird, die für jeden Erfassungszeitpunkt des Lernzeitraums bestimmt werden, wobei jede momentane Leistung anhand der Temperatur der Luft am Auslass des Gehäuses zu einem Erfassungszeitpunkt des Lernzeitraums, der Temperatur der Luft außerhalb des Gehäuses zu dem Erfassungszeitpunkt des Lernzeitraums und eines Ausgangsluftvolumenstroms des Lüfters (3) bestimmt wird.

5. Bestimmungsverfahren nach Anspruch 1, **dadurch gekennzeichnet, dass** es einen Schritt des Erfassens von Temperaturdaten der Luft außerhalb des Gehäuses (1) während des Bewertungszeitraums ($T_{EVAL}$) zu bestimmten Erfassungszeitpunkten beinhaltet, die durch ein regelmäßiges Zeitintervall ($t_{EVAL}$) getrennt sind.

6. Bestimmungsverfahren nach Anspruch 5, **dadurch gekennzeichnet, dass** es einen Schritt des Erfassens von Temperaturdaten der Luft am Auslass des Gehäuses (1) während des Bewertungszeitraums zu bestimmten Erfassungszeitpunkten beinhaltet, die durch das regelmäßige Zeitintervall ($t_{EVAL}$) getrennt sind.

7. Bestimmungsverfahren nach Anspruch 6, **dadurch gekennzeichnet, dass** es während der Bewertungsphase einen Schritt des Bestimmens des momentanen Luftvolumenstroms (D(i)) des Lüfters (3) zu jedem der Erfassungszeitpunkte des Bewertungszeitraums anhand der durch Joule-Effekt von den im Gehäuse aufgenommenen elektrischen Geräten (2) abgegebenen und während der Lernphase (APP) zu einem entsprechenden Zeitpunkt des Lernzeitraums ($T_{APP}$) bestimmten Leistung, der zu dem Zeitpunkt gemessenen Temperatur der Luft außerhalb des Gehäuses und der zu dem Zeitpunkt gemessenen Temperatur der Luft am Auslass des Gehäuses beinhaltet.

8. Bestimmungsverfahren nach Anspruch 7, **dadurch gekennzeichnet, dass** der mittlere Volumenstrom ($D_{moyen}$) dem Mittelwert der momentanen Volumenströme entspricht, die zu jedem Zeitpunkt bestimmt werden, wenn der Lüfter in Betrieb ist.

9. Bestimmungsverfahren nach einem der Ansprüche 1 bis 8, **dadurch gekennzeichnet, dass** die Schwellenwerte anhand eines Ausgangsluftvolumenstroms des Lüfters (3) festgelegt werden.

10. System zum Bestimmen des Effizienzniveaus eines Belüftungssystems eines elektrischen Gehäuses (1), das dazu bestimmt ist, ein oder mehrere elektrische Geräte (2) aufzunehmen, wobei das Belüftungssystem einen Lufteinlass (4), mindestens einen Lüfter (3), um das Einblasen von Luft in den Innenraum des Gehäuses (1) im Hinblick auf das Kühlen jedes elektrischen Geräts (2) zu begünstigen, einen Lufteinlassfilter (40), der dazu eingerichtet ist, die in den Innenraum des Gehäuses (1) eingeblasene Luft zu filtern, und einen Luftauslass (5), der dazu eingerichtet ist, das Abführen der warmen Luft aus dem Gehäuse (1) heraus zu ermöglichen, umfasst, **dadurch gekennzeichnet, dass** es eine Verarbeitungseinheit beinhaltet, die umfasst:

- ein Lernmodul, das ein Bestimmungsmodul (M1) zum Bestimmen eines Profils der durch Joule-Effekt in dem elektrischen Gehäuse (1) von jedem elektrischen Gerät abgegebenen Leistung während eines Lernzeitraums ($T_{APP}$) umfasst,
- ein Bewertungsmodul (EVAL) zum Bewerten des Effizienzniveaus des Belüftungssystems, das umfasst:

- ein Bestimmungsmodul (M3) zum Bestimmen des mittleren Luftvolumenstroms des Lüfters (3) über einen Bewertungszeitraum ($T_{EVAL}$) anhand eines über den Bewertungszeitraum erhaltenen Profils der Temperatur der Luft außerhalb des Gehäuses, eines Profils der Temperatur der Luft am Auslass des Gehäuses und des während der Lernphase bestimmten Profils der abgegebenen Leistung,
- ein Vergleichsmodul (M4) zum Vergleichen des über den Bewertungszeitraum bestimmten mittleren Luftvolumenstroms ($D_{moyen}$) mit einem oder mehreren Schwellenwerten im Hinblick auf das Bestimmen des Effizienzniveaus des Belüftungssystems.

11. Bestimmungssystem nach Anspruch 10, **dadurch gekennzeichnet, dass** die Verarbeitungseinheit (UC) dazu eingerichtet ist, Temperaturdaten der Luft außerhalb des Gehäuses während des Lernzeitraums zu bestimmten Erfassungszeitpunkten (i) zu erfassen, die durch ein regelmäßiges Zeitintervall ($t_{APP}$) getrennt sind.

12. Bestimmungssystem nach Anspruch 11, **dadurch gekennzeichnet, dass** die Verarbeitungseinheit dazu eingerichtet ist, Temperaturdaten der Luft am Auslass des Gehäuses während des Lernzeitraums zu bestimmten Erfassungszeitpunkten zu erfassen, die durch das regelmäßige Zeitintervall ($t_{APP}$) getrennt sind.

13. Bestimmungssystem nach Anspruch 12, **dadurch gekennzeichnet, dass** das Profil der durch Joule-Effekt von den elektrischen Geräten abgegebenen Leistung anhand der momentanen Leistungen ($P(i)$) erstellt wird, die für jeden Erfassungszeitpunkt des Lernzeitraums bestimmt werden, wobei jede momentane Leistung von einem Modul (M1) anhand der Temperatur der Luft am Auslass des Gehäuses zu einem Erfassungszeitpunkt des Lernzeitraums, der Temperatur der Luft außerhalb des Gehäuses zu dem Erfassungszeitpunkt des Lernzeitraums und eines Ausgangsluftvolumenstroms des Lüfters (3) bestimmt wird.

14. Bestimmungssystem nach Anspruch 10, **dadurch gekennzeichnet, dass** die Verarbeitungseinheit (UC) dazu eingerichtet ist, Temperaturdaten der Luft außerhalb des Gehäuses (1) während des Bewertungszeitraums ($T_{EVAL}$) zu bestimmten Erfassungszeitpunkten zu erfassen, die durch ein regelmäßiges Zeitintervall ($t_{EVAL}$) getrennt sind.

15. Bestimmungssystem nach Anspruch 14, **dadurch gekennzeichnet, dass** die Verarbeitungseinheit (UC) dazu eingerichtet ist, Temperaturdaten der Luft am Auslass des Gehäuses (1) während des Bewertungszeitraums zu bestimmten Erfassungszeitpunkten zu erfassen, die durch das regelmäßige Zeitintervall ($t_{EVAL}$) getrennt sind.

16. Bestimmungssystem nach Anspruch 15, **dadurch gekennzeichnet, dass** das Bewertungsmodul ein Modul (M2) zum Bestimmen des momentanen Luftvolumenstroms ($D(i)$) des Lüfters (3) zu jedem der Erfassungszeitpunkte des Bewertungszeitraums anhand der durch Joule-Effekt von den im Gehäuse aufgenommenen elektrischen Geräten (2) abgegebenen und während der Lernphase (APP) zu einem entsprechenden Zeitpunkt des Lernzeitraums ($T_{APP}$) bestimmten Leistung, der zu dem Zeitpunkt gemessenen Temperatur der Luft außerhalb des Gehäuses und der zu dem Zeitpunkt gemessenen Temperatur der Luft am Auslass des Gehäuses beinhaltet.

17. Bestimmungssystem nach Anspruch 16, **dadurch gekennzeichnet, dass** der mittlere Volumenstrom ($D_{moyen}$) dem Mittelwert der momentanen Volumenströme entspricht, die zu jedem Zeitpunkt bestimmt werden, wenn der Lüfter in Betrieb ist.

18. Bestimmungssystem nach einem der Ansprüche 10 bis 17, **dadurch gekennzeichnet, dass** die Schwellenwerte anhand eines Ausgangsluftvolumenstroms des Lüfters (3) festgelegt werden.

**Claims**

1. Method for determining the level of efficiency of a ventilation system of an electrical enclosure (1) intended to house one or more electrical devices (2), said ventilation system comprising an air inlet (4), at least one fan (3) for assisting injection of air inside the enclosure (1) in order to cool each electrical device (2), an air inlet filter (40) designed to filter the air injected inside the enclosure (1) and an air outlet (5) designed to allow evacuation of the hot air outside the enclosure (1), **characterized in that** it comprises:

   - a learning step (APP) comprising a step for determining a profile of the power dissipated by the Joule effect inside the electrical enclosure (1) by each electrical device, during a learning period ($T_{APP}$),
   - an evaluation step (EVAL) for evaluating the level of efficiency of ventilation system, comprising:

     - a step for determining the average air flow rate of the fan over an evaluation period ($T_{EVAL}$) from a profile of the temperature of the air outside the enclosure obtained over said evaluation period, a profile of the temperature of the air at the outlet of the enclosure, and said dissipated power profile determined during the learning step,
     - a step for comparing the average air flow rate ($D_{moyen}$) determined over said evaluation period with one or more threshold values in order to determine the level of efficiency of the ventilation system.

2. Determination method according to Claim 1, **characterized in that** it comprises a step of collecting data relating to temperatures of the air outside the enclosure during the learning period at given collection instants (i) separated by a regular time interval ($t_{APP}$).

3. Determination method according to Claim 2, **characterized in that** it comprises a step of collecting data relating to temperatures of the air at the outlet of the enclosure during the learning period at given collection instants separated by said regular time interval ($t_{APP}$).

4. Determination method according to Claim 3, **characterized in that** the profile of the power dissipated via the Joule effect by the electrical devices is obtained from the instantaneous power values ($P(i)$) determined for each collection instant of the learning period, each instantaneous power value being determined from the temperature of the air at the outlet of the enclosure at a collection instant of the learning period, the temperature of the air outside the enclosure at said collection instant of the learning period, and an initial air flow rate of the fan (3).

5. Determination method according to Claim 1, **characterized in that** it comprises a step of collecting data relating to temperatures of the air outside the enclosure (1) during the evaluation period ($T_{EVAL}$) at given collection instants separated by a regular time interval (tEVAL).

6. Determination method according to Claim 5, **characterized in that** it comprises a step of collecting data relating to temperatures of the air at the outlet of the enclosure (1) during the evaluation period at given collection instants separated by said regular time interval ($t_{EVAL}$).

7. Determination method according to Claim 6, **characterized in that**, during the evaluation step, it comprises a step for determining the instantaneous air flow rate ($D(i)$) of the fan (3) at each of the collection instants of the evaluation period, from the power dissipated via the Joule effect by the electrical devices (2) housed inside the enclosure and determined during the learning step (APP) at a corresponding instant of the learning period ($T_{APP}$), the temperature of the air outside the enclosure measured at said instant, and the temperature of the air at the outlet of the enclosure measured at said instant.

8. Determination method according to Claim 7, **characterized in that** the average flow rate ($D_{moyen}$) corresponds to the average of the instantaneous flow rates determined at each instant when the fan is in operation.

9. Determination method according to one of Claims 1 to 8, **characterized in that** the threshold values are fixed based on an initial air flow rate of the fan (3).

10. System for determining the level of efficiency of a ventilation system of an electrical enclosure (1) intended to house one or more electrical devices (2), said ventilation system comprising an air inlet (4), at least one fan (3) for assisting injection of air inside the enclosure (1) in order to cool each electrical device (2), an air inlet filter (40) designed to filter the air injected inside the enclosure (1) and an air outlet (5) designed to allow evacuation of the hot air outside the enclosure (1), **characterized in that** it comprises a processing unit comprising:

- a learning module comprising a module (M1) for determining a profile of the power dissipated by the Joule effect inside the electrical enclosure (1) by each electrical device, during a learning period ($T_{APP}$),
- an evaluation module (EVAL) for evaluating the level of efficiency of the ventilation system, comprising:

- a module (M3) for determining the average air flow rate of the fan (3) over an evaluation period ($T_{EVAL}$) from a profile of the temperature of the air outside the enclosure obtained over said evaluation period, a profile of the temperature of the air at the outlet of the enclosure, and said dissipated power profile determined during the learning step,
- a module (M4) for comparing the average air flow rate ($D_{moyen}$) determined over said evaluation period with one or more threshold values in order to determine the level of efficiency of the ventilation system.

11. Determination system according to Claim 10, **characterized in that** the processing unit (UC) is designed to collect data relating to temperatures of the air outside the enclosure during the learning period at given collection instants (i) separated by a regular time interval ($t_{APP}$).

12. Determination system according to Claim 11, **characterized in that** the processing unit is designed to collect data relating to temperatures of the air at the outlet of the enclosure during the learning period at given collection instants separated by said regular time interval ($t_{APP}$).

13. Determination system according to Claim 12, **characterized in that** the profile of the power dissipated via the Joule effect by the electrical devices is obtained from the instantaneous power values (P(i)) determined for each collection instant of the learning period, each instantaneous power value being determined by a module (M1) from the temperature of the air at the outlet of the enclosure at a collection instant of the learning period, the temperature of the air outside the enclosure at said collection instant of the learning period, and an initial air flow rate of the fan (3).

14. Determination system according to Claim 10, **characterized in that** the processing unit (UC) is designed to collect data relating to temperatures of the air outside the enclosure (1) during the evaluation period ($T_{EVAL}$) at given collection instants separated by a regular time interval ($t_{EVAL}$).

15. Determination system according to Claim 14, **characterized in that** the processing unit (UC) is designed to collect data relating to temperatures of the air at the outlet of the enclosure (1) during the evaluation period at given collection instants separated by said regular time interval ($t_{EVAL}$).

16. Determination system according to Claim 15, **characterized in that** the evaluation module comprises a module (M2) for determining the instantaneous air flow rate (D(i)) of the fan (3) at each of the collection instants of the evaluation period, from the power dissipated via the Joule effect by the electrical devices (2) housed inside the enclosure and determined during the learning step (APP) at a corresponding instant of the learning period ($T_{APP}$), the temperature of the air outside the enclosure measured at said instant, and the temperature of the air at the outlet of the enclosure measured at said instant.

17. Determination system according to Claim 16, **characterized in that** the average flow rate rate ($D_{moyen}$) corresponds to the average of the instantaneous flow rates determined at each instant when the fan is in operation.

18. Determination system according to one of Claims 10 to 17, **characterized in that** the threshold values are fixed based on an initial air flow rate of the fan (3).

Fig. 1

**Fig. 2**

**EP 3 200 574 B1**

## RÉFÉRENCES CITÉES DANS LA DESCRIPTION

**Documents brevets cités dans la description**

- EP 2077145 A

- US 2011316706 A